# NOUVEAU FASCICULE DE BREVET EUROPEEN

(11) **EP 2 259 997 B2**
(45) Date de publication et mention de la décision concernant l'opposition: **30.09.2015**
(45) Mention de la délivrance du brevet: 01.06.2011
(21) Numéro de dépôt: 08848955.4
(22) Date de dépôt: 12.11.2008
(51) Int. Cl.: B81C 99/00, C25D 1/00, G04B 13/00

(54) **PROCEDE DE FABRICATION D'UNE PIECE DE MICROMECANIQUE COMPOSITE SILICIUM-METAL**
HERSTELLUNGSVERFAHREN FÜR EIN MIKROMECHANISCHES TEIL AUS EINEM SILIZIUM-METALL-VERBUND
METHOD FOR MANUFACTURING A COMPOSITE SILICON-METAL MICROMECHANICAL COMPONENT

(30) Priorité: 16.11.2007 EP 07120883
(43) Date de publication de la demande: 15.12.2010
(73) Titulaire: Nivarox-FAR S.A., 2400 Le Locle (CH)
(72) Inventeur: FIACCABRINO, Jean-Charles, CH-1421 Grandevent (CH); VERARDO, Marco, CH-2336 Les Bois (CH); CONUS, Thierry, CH-2543 Lengnau (CH); THIÉBAUD, Jean-Philippe, CH-1588 Cudrefin (CH); PETERS, Jean-Bernard, CH-2542 Pieterlen (CH)
(74) Mandataire: Couillard, Yann Luc Raymond
(86) Numéro de dépôt international: PCT/EP2008/065347
(87) Numéro de publication internationale: WO 2009/062943

(56) Documents cités:
- US-A1- 2007 103 177
- PERRET A ET AL: "Silicon as material for mechanical wristwatches" PROCEEDINGS OF THE SPIE - THE INTERNATIONAL SOCIETY FOR OPTICAL ENGINEERING SPIE-INT. SOC. OPT. ENG USA, vol. 4755, 2002, pages 645-647, XP007907742 ISSN: 0277-786X
- KOUBA J ET AL: "SU-8: promising resist for advanced direct LIGA applications for high aspect ratio mechanical microparts" MICROSYSTEM TECHNOLOGIES ; MICRO AND NANOSYSTEMS INFORMATION STORAGE AND PROCESSING SYSTEMS, SPRINGER, BERLIN, DE, vol. 13, no. 3-4, 7 juillet 2006 (2006-07-07), pages 311-317, XP019474557 ISSN: 1432-1858
- XP55186088 Sigatec SA: a start-up company for Silicon Microparts

## Description

### DOMAINE DE L'INVENTION

L'invention se rapporte à un procédé de fabrication d'une pièce de micromécanique composite silicium - métal.

### ARRIERE PLAN DE L'INVENTION

Le silicium est connu tribologiquement pour son faible coefficient de frottement. Son application dans l'horlogerie mécanique est intéressante notammerit pour les systèmes d'échappement et plus précisément pour les pignons d'impulsion d'une roue d'échappement. Cependant, le silicium est également connu mécaniquement pour sa faible zone plastique de sorte que son adaptation notamment aux techniques habituelles de chassage sur axe est rendue difficile par son caractère cassant.

### RESUME DE L'INVENTION

Le but de la présente invention est de pallier tout ou partie les inconvénients cités précédemment en proposant un procédé de fabrication permettant avantageusement la réalisation d'une pièce de micromécanique composite apte à s'adapter à la plupart des applications horlogères.

A cet effet, l'invention se rapporte à un procédé de fabrication d'une pièce de micromécanique composite silicium - métal comprenant les étapes suivantes :
a) se munir d'un substrat comportant une couche supérieure et une couche inférieure en silicium entre lesquelles s'étend une couche intermédiaire d'oxyde de silicium ;
b) graver sélectivement au moins une cavité dans la couche supérieure pour définir le motif d'une partie en silicium de ladite pièce ;
c) continuer la gravure de ladite au moins une cavité dans la couche intérmédiairé ;
caractérisé en ce qu'il comporte en outre les étapes suivantes :
d) faire croître une couche métallique au moins à partir d'une portion de ladite au moins une cavité afin de former une partie métallique dans l'épaisseur de ladite pièce afin d'isoler mécaniquement la partie en silicium d'efforts destructifs ;
e) libérer la pièce de micromécanique composite silicium - métal du substrat.

Le procédé permet avantageusement d'obtenir une pièce monobloc qui permet de jouir des caractéristiques tribologiques du silicium et des caractéristiques mécaniques du métal.

Conformément à d'autres caractéristiques avantageuses de l'invention :
- l'étape d) comporte les étapes suivantes :
   - recouvrir de résine photosensible le dessus du substrat ;
   - réaliser sélectivement une photolithographie de la résine photosensible afin de la photostructure en fonction du motif prédéterminé de la partie métallique ;
   - déposer une couche métallique par électrodéposition à partir de la face supérieure conductrice de la couche inférieure qui est à l'aplomb de ladite au moins une cavité en y faisant croître, à partir du fond, la couche entre respectivement la résine photostructurée et la couche intermédiaire ou supérieure permettant de former la partie métallique selon ledit motif ;
   - et en ce que l'étape e) est réalisée en éliminant la résine photostructurée.
- ladite face supérieure conductrice de la couche inférieure qui est à l'aplomb de ladite au moins une cavité est rendue conductrice par dopage de la couche inférieure et/ou par dépôt d'une couche conductrice ;
- la résine photostructurée lors de l'étape de photolithographie fait saillie de la couche supérieure du substrat afin de pouvoir continuer la croissance de la couche par électrodéposition au moins entre lesdites saillies de la résine photostructurée dans le but de former une deuxième partie métallique de la pièce de micromécanique au-dessus de la partie en silicium ;
- le procédé comporte, après l'étape d), une étape d'usinage de la face supérieure du substrat afin de niveler la couche métallique à la même hauteur que l'extrémité supérieure de ladite résine photostructurée ;
- la couche métallique comporte du nickel ;
- le procédé comporte, avant l'étape de libération, des étapes d'usinage et de gravage d'au moins une cavité dans la couche inférieure du substrat afin de former une seconde partie en silicium de la pièce de micromécanique selon une forme et une épaisseur déterminée ;
- le procédé comporte, entre les étapes d'usinage et de gravage de la couche inférieure du substrat et l'étape de libération, une étape de croissance d'une deuxième couche métallique par électrodéposition dans au moins une portion de ladite au moins une cavité de la couche inférieure afin de former au moins une partie métallique supplémentaire dans l'épaisseur de la couche inférieure ;
- l'étape de croissance comporte les étapes suivantes :
   - recouvrir de résine photosensible le dessous du substrat ;
   - réaliser sélectivement une photolithographie de la résine photosensible afin de la photostructurer en fonction du motif prédéterminé de la partie métallique ;
   - déposer une couche métallique par électrodéposition à partir du fond de ladite au moins une cavité en y faisant croître, à partir du fond, la couche permettant de former la partie métallique selon ledit motif ;
   - la résine photostructurée lors de l'étape de photolithographie fait saillie de la couche inférieure du substrat afin de pouvoir continuer la croissance de la couche par électrodéposition dans le but de former une deuxième partie métallique supplémentaire de la pièce de micromécanique en dessous de la deuxième partie en silicium ;
   - le procédé comporte, avant l'étape de libération, une étape d'usinage de la face inférieure du substrat afin de niveler la partie métallique à la même hauteur que l'extrémité inférieure de ladite résine photostructurée ;
   - la deuxième couche métallique électrodéposée comporte du nickel ;
   - plusieurs pièces de micromécanique sont fabriquées sur le même substrat.

Enfin, l'invention se rapporte à une pièce d'horlogerie caractérisée en ce qu'elle comporte au moins une pièce de micromécanique composite conforme à l'une des variantes précédentes.

### DESCRIPTION SOMMAIRE DES DESSINS

D'autres particularités et avantages ressortiront clairement de la description qui en est faite ci-après, à titre indicatif et nullement limitatif, en référence aux dessins annexés, dans lesquels :
- les figures 1 à 7 sont des sections d'une pièce de micromécanique composite à différentes phases du procédé de fabrication selon l'invention ;
- la figure 1b est une représentation de la figure 1 en perspective.
- la figure 8 est une représentation d'un premier exemple d'étape finale selon le procédé de l'invention ;
- la figure 9 est une représentation d'un deuxième exemple d'étape finale selon le procédé de l'invention ;
- la figure 10 est un schéma fonctionnel du procédé de fabrication selon l'invention ;
- la figure 11 est une représentation en perspective d'un rouage obtenu selon le procédé de l'invention ;
- la figure 12 est une représentation vue de dessus d'une aiguille obtenue selon l'invention ;

### DESCRIPTION DETAILLEE DES MODES DE REALISATION PREFERES

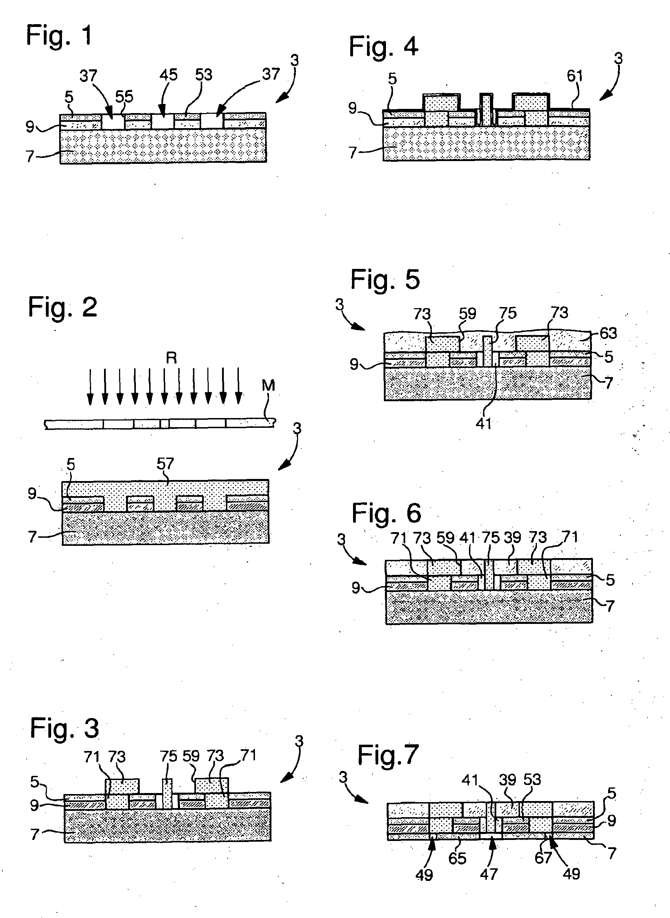

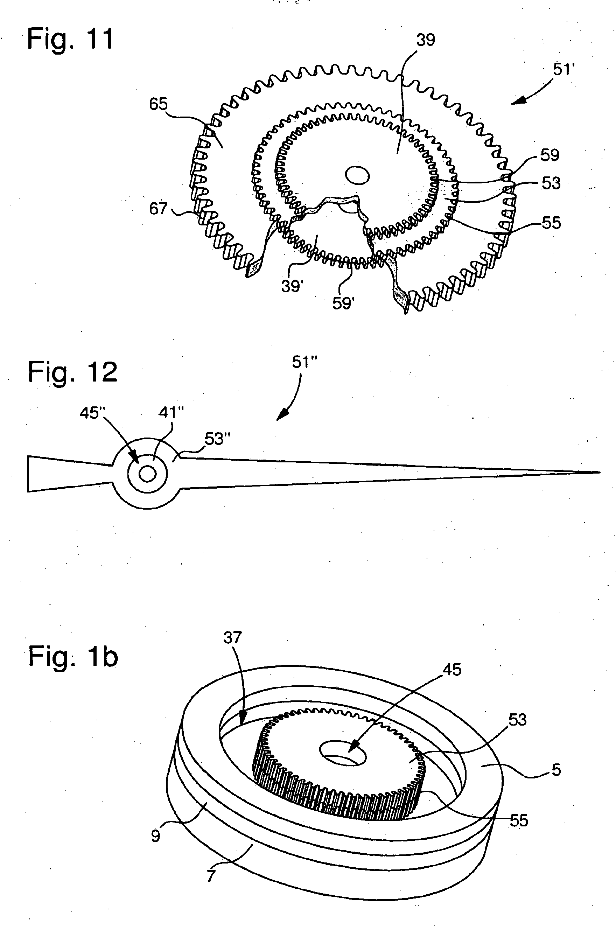

L'invention se rapporte à un procédé de fabrication 1 d'une pièce de micromécanique composite 51 silicium - métal. Comme visible aux figures 1 à 7, le procédé 1 comporte des étapes successives destinées à former au moins une pièce 51, 51', 51", 51 "' qui peut être complexe et/ou sur plusieurs couches et/ou avec plusieurs matériaux. Le but du présent procédé 1 consiste au minimum à offrir une pièce comportant au moins une partie en silicium et au moins une partie en métal.

La première étape 11 consiste à se munir d'un substrat 3 du type « silicium sur isolant », très connu sous l'acronyme anglais « SOI ». Le substrat 3 comporte une couche supérieure 5 et une couche inférieure 7 composées de silicium mono ou polycristallin. Entre les couches supérieure 5 et inférieure 7 s'étend une couche intermédiaire 9 composée d'oxyde de silicium du type amorphe (SiO₂).

Préférentiellement dans cette étape 11, le substrat 3 est choisi afin que, comme visible à la figure 1, la hauteur des couches supérieure 5 et intermédiaire 9 corresponde à la hauteur finale d'une partie 53 de la pièce de micromécanique finale 51.

Dans une deuxième étape 13, comme visible aux figures 1 & 1b, des cavités 37, 45 sont sélectivement gravées, par exemple par un procédé du type DRIE (acronyme très connu provenant de l'anglais « deep reactive ion etching »), dans la couche supérieure 5 en silicium. Ces deux cavités 37 et 45 permettent de former le motif définissant les contours intérieur et extérieur de la partie 53 en silicium de la pièce de micromécanique 51.

Dans l'exemple illustré à la figure 1, la cavité 37 est présente de chaque côté de la cavité 45 car, comme visible à la figure 1b, elle est sensiblement annulaire et entoure la cavité 45. Préférentiellement, la paroi proximale de la cavité 37 est sélectivement gravée afin de former une denture 55 sur le bord périphérique de la partie 53. La cavité 45 est sensiblement cylindrique à section discoïdale et est coaxiale par rapport à la cavité annulaire 37.

Dans une troisième étape 15, un gravage par attaque chimique humide ou sèche est réalisée pour prolonger, dans la couche intermédiaire 9, les cavités 37 et 45 afin que la partie 53 soit formée selon le même motif dans la couche intermédiaire 9 jusqu'à découvrir partiellement la couche inférieure 7.

Le procédé 1 selon l'invention comporte ensuite la mise en oeuvre d'un processus 19 du type LIGA (acronyme très connu provenant de l'allemand « Röntgenlithographie, Galvanoformung & Abformung ») comportant une succession d'étapes (17, 21 & 23) permettant d'électrodéposer selon une forme particulière un métal sur la face supérieure du substrat 3 à l'aide d'une résine photostructurée.

Dans une quatrième étape 17, on dépose, sur la face supérieure du substrat 3, une couche de résine photosensible 57 comme visible à la figure 2. L'étape 17 peut être réalisée par exemple à l'aide d'un procédé du type coulée par moule (connu également sous les termes anglais « mould casting »). Préférentiellement, la résine photosensible 57 est du type Su-8 comme par exemple le produit « nano^{™} Su-8 » de l'entreprise Microchem Corp.

Dans une cinquième étape 21, on réalise une photolithographie, c'est-à-dire qu'on expose sélectivement à un rayonnement R, au moyen par exemple d'un masque M partiellement ajouré comme visible à la figure 2, pour réaliser une impression de ladite résine. Ensuite, on développe la résine 57, c'est-à-dire qu'on retire toutes les portions de la résine 57 qui n'ont pas été exposées au rayonnement R. La résine ainsi photostructurée 71, 73 & 75 permet de réaliser, selon la forme particulière prédéterminée, la couche métallique.

Dans l'exemple de la figure 3, la résine photostructurée comporte un anneau inférieur 71, un anneau supérieur 73 et un cylindre 75. Dans l'exemple de la figure 3, l'anneau inférieur 71 est de forme correspondante à la cavité 37. L'anneau supérieur 73 recouvre l'anneau inférieur 71 et, partiellement, la couche supérieure 5 du substrat 3. Enfin, le cylindre 75 possède une hauteur sensiblement équivalente à l'épaisseur de l'empilement des anneaux 71 et 73 et est monté centré dans la cavité 45. Dans l'exemple illustré aux figures 1 à 7, le diamètre intérieur de l'anneau supérieur 73 comporte une denture 59.

Préférentiellement dans une sixième étape 29, on dépose sur la face supérieure du substrat 3 une couche 61 d'accrochage conductrice comme visible à la figure 4. Cette étape peut être réalisée par exemple par un procédé conventionnel de métallisation sous vide par pulvérisation cathodique. Préférentiellement, la couche 61 comporte de l'or, c'est-à-dire de l'or pur ou un de ses alliages. L'épaisseur de la couche 61 peut être comprise entre 10 et 100 nm.

Dans une septième étape 23, on réalise par électrodéposition le départ d'une couche métallique sur la face supérieure du substrat 3, c'est-à-dire que l'on fait croître un couche 63 métallique afin de former au moins une partie métallique 41 de la pièce de micromécanique 51. Dans l'exemple illustré à la figure 5, la couche 63 commence sensiblement sur la face supérieure de la couche inférieure 7 mise à nue par la cavité 45.

La présence du cylindre 75 de résine photostructurée oblige la croissance de la couche métallique 63 à se former par couches annulaires successives entre le cylindre 75 et la couche intermédiaire 9 puis entre le cylindre 75 et la couche supérieure 5 du substrat 3. Cette première phase d'électrodéposition permet de former une première partie 41 métallique dans au moins une portion de la cavité 45.

On comprend donc à cette première phase de l'étape 23 que la pièce de micromécanique 51 est désormais formée sur une couche qui comporte une partie 53 en silicium et en oxyde de silicium dont au moins une portion d'une des cavités 45 comporte une partie 41 métallique.

Dans l'exemple illustré à la figure 5, l'électrodéposition est continuée ce qui forme des couches non plus dans la cavité 45 mais au-dessus et également sur une partie de la couche supérieure 5 du substrat 3. Les couches successives sont alors formées exclusivement entre l'anneau supérieur 73 et le cylindre 75 de résine photostructurée. On comprend donc que la couche 39 formée dans la deuxième phase est de forme sensiblement annulaire dont le diamètre extérieur comporte une denture inverse à celle 59 de l'anneau supérieur 73 en résine photostructurée. A la fin de l'étape 23, il peut arriver qu'on obtienne une couche 63 de métal sur toute la face supérieure du substrat 3 comme visible à la figure 5.

Préférentiellement, la couche 63, c'est-à-dire notamment les parties métalliques 39 et 41 comporte du nickel, c'est-à-dire du nickel pur ou un de ses alliages. Préférentiellement, la différence de potentiel du substrat 3 nécessaire à l'étape 23 d'électrodéposition est réalisée par contact sur sa face inférieure et/ou supérieure.

Dans une huitième étape 25, un usinage de la face supérieure du substrat 3 est réalisée, par exemple par rodage, afin de niveler la hauteur de la partie métallique 39, obtenue lors ladite deuxième phase de l'étape 23, par rapport à l'épaisseur de l'anneau supérieur 73 et du cylindre 75 en la résine photostructurée comme visible à la figure 6. Cela permet notamment de correctement délimiter la deuxième partie 39 métallique comportant la denture inverse (ci-après référencée 59).

On comprend donc à cette étape 25 que la pièce de micromécanique 51 est désormais formée sur deux couches. La première couche comporte une partie 53 en silicium et en oxyde de silicium dont au moins une portion d'une des cavités 45 comporte une partie 41 métallique. La deuxième couche formée au-dessus de la première est formée par une deuxième partie 39 métallique.

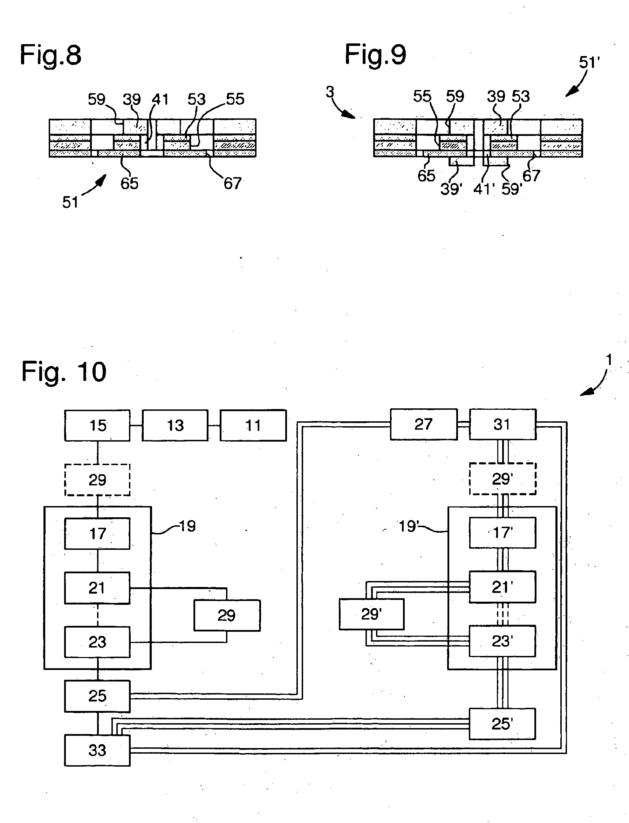

Dans des neuvième et dixième étapes 27 & 31, comme illustré par les doubles traits à la figure 10, on forme une deuxième partie 65 en silicium dans la couche inférieure 7 du substrat 3. Lors de l'étape 27, un usinage est réalisé sur la face inférieure du substrat 3 afin de diminuer l'épaisseur jusqu'à la valeur de la couche inférieure 7 finale souhaitée. Lors de l'étape 31, des cavités 47, 49 sont gravées, par exemple par un procédé du type DRIE, dans la couche inférieure 7 en silicium. Ces deux cavités 47 et 49, de la même manière que pour les étapes 13 & 15, permettent de former le motif définissant le contour de la deuxième partie 65 en silicium de la pièce de micromécanique 51.

Dans l'exemple illustré à la figure 7, la cavité 49 est présente de chaque côté de la cavité 47 car elle est sensiblement annulaire et entoure la cavité 47. Préférentiellement, la paroi proximale de la cavité 49 est sélectivement gravée afin de former une denture 67 sur le bord périphérique de la deuxième partie 65. La cavité 47 est sensiblement cylindrique à section discoïdale et coaxiale par rapport à la cavité annulaire 49.

Les étapes 27 et 31 n'ont pas une consécutivité préférée, de sorte que l'une peut être initiée avant l'autre et inversement. Préférentiellement, l'étape 27 d'usinage peut consister en un polissage mécano-chimique comme un rodage par abrasion chimique.

On comprend donc que, après ces étapes 27 & 31, la pièce de micromécanique 51 est désormais formée sur trois couches. La première couche comporte une partie 53 en silicium et en oxyde de silicium dont au moins une portion d'une des cavités 45 comporte une partie 41 métallique. La deuxième couche au-dessus de la première est formée par une deuxième partie 39 métallique. La troisième couche en dessous de la première est formée par une deuxième partie 65 en silicium.

Le procédé 1 selon l'invention comporte ensuite, comme illustré par les triples traits à la figure 10, la mise en oeuvre d'un nouveau processus 19' du type LIGA comportant une succession d'étapes (17', 21' & 23') permettant d'électrodéposer selon une forme particulière un métal sur la face inférieure du substrat 3 à l'aide d'une résine photostructurée.

Dans une onzième étape 17', on dépose sur la face inférieure du substrat 3 une couche de résine photosensible, par exemple à l'aide d'un procédé du type coulée par moule. Dans une douzième étape 21', on réalise une photolithographie permettant de réaliser le motif de la croissance de la future électrodéposition métallique.

Préférentiellement dans une treizième étape 29', on dépose sur la face inférieure du substrat 3 une couche d'accrochage. Cette étape peut être réalisée, par exemple, par dépôt sous vide, comme mentionné ci-dessus, d'une couche d'or pur ou un de ses alliages.

Dans une quatorzième étape 23', on réalise par électrodéposition une couche métallique sur la face inférieure du substrat 3 afin de former au moins une partie supplémentaire métallique 41' de la pièce de micromécanique 51 dans au moins une portion de la cavité 47.

On comprend donc à cette étape que la pièce de micromécanique 51 est toujours formée sur trois couches. La première couche comporte une partie 53 en silicium et en oxyde de silicium dont au moins une portion d'une des cavités 45 comporte une partie 41 métallique. La deuxième couche au-dessus de la première est formée par une deuxième partie 39 métallique. La troisième couche en dessous de la première est formée par une deuxième partie 65 en silicium dont au moins une portion d'une des cavités 47 comporte une partie supplémentaire 41' métallique.

L'étape 23' d'électrodéposition peut être continuée afin de former des couches non plus dans la cavité 47 mais en dessous et, éventuellement, sur une partie de la couche inférieure 7 du substrat 3. Les couches successives sont alors formées exclusivement entre la résine, photostructurée lors de l'étape 21', en une deuxième partie supplémentaire 39' métallique.

Préférentiellement, la couche métallique électrodéposée, c'est-à-dire notamment les parties métalliques supplémentaires 39' et 41' comporte du nickel, c'est-à-dire du nickel pur ou un de ses alliages.

Dans une quinzième étape 25', un usinage de la face inférieure du substrat 3 est réalisée, par exemple par rodage, afin de correctement délimiter la deuxième partie supplémentaire métallique 39'. De manière similaire à la deuxième partie 39, la deuxième partie supplémentaire 39' métallique peut également comporter une denture 59'.

On comprend donc à cette étape que la pièce de micromécanique 51 est désormais formée sur quatre couches. La première couche comporte une partie 53 en silicium & en oxyde de silicium dont au moins une portion d'une des cavités 45 comporte une partie 41 métallique. La deuxième couche au-dessus de la première est formée par une deuxième partie 39 métallique. La troisième couche en dessous de la première est formée par une deuxième partie 65 en silicium dont au moins une portion d'une des cavités 47 comporte une partie supplémentaire 41' métallique. La quatrième couche en dessous de la troisième est formée par une deuxième partie supplémentaire 39' métallique.

Bien entendu, l'intérêt d'un tel procédé est aussi de permettre, avantageusement, la réalisation de plusieurs pièces de micromécanique 51 sur un même substrat 3. De plus, à l'aide de l'explication ci-dessus et des traits simple, double et triple de la figure 10, il faut comprendre que le procédé 1 peut ne pas être entièrement réalisé, c'est-à-dire que suivant la complexité de la pièce de micromécanique 51 à fabriquer, on peut achever sa construction, par exemple, après l'étape 25, 31 ou 25'. Néanmoins pour chaque variante de construction, le procédé 1 comporte une dernière étape 33 consistant à libérer la pièce de micromécanique 51 du substrat 3. A titre d'exemples, il est expliqué ci-après plusieurs modes de réalisation du procédé 1 et/ou de la pièce de micromécanique 51.

Dans un premier mode de réalisation, l'étape de libération 33 du procédé 1 est réalisée après l'étape 25 de construction de la partie métallique 41 dans la partie 53 en silicium comme visualisé par les simples traits à la figure 10. L'étape de libération 33 consiste alors à éliminer la résine photostructurée ainsi que la couche inférieure 7 ou les couches inférieure 7 et intermédiaire 9. La pièce de micromécanique 51" ainsi fabriquée est libre par rapport au reste du substrat 3. Elle comporte, comme visible à la figure 12, ainsi, sur une couche unique comportant une partie 53" en silicium ou en silicium et en oxyde de silicium formant le corps d'une aiguille dont au moins un portion d'une des cavités 45" comporte une partie 41 " métallique formant chemise.

Dans un deuxième mode de réalisation illustré à la figure 8, on voit que, par exemple, l'étape de libération 33 du procédé 1 est réalisée après l'étape 31 de construction de la deuxième partie 65 en silicium comme visualisé par les doubles traits à la figure 10. L'étape de libération 33 consiste alors à éliminer les parties 71, 73 et 75 de résine photostructurée par exemple au moyen d'une attaque chimique et/ou mécanique (qui peut être une méthode connue par le terme anglais « stripping »). La pièce de micromécanique 51 ainsi fabriquée est libre par rapport au reste du substrat 3. Elle comporte, sur trois couches empilées, une deuxième partie 39 métallique, une partie 53 en silicium et en oxyde de silicium dont au moins une portion d'une des cavités 45 comporte une partie 41 métallique et une deuxième partie 65 en silicium.

La pièce de micromécanique 51 obtenue selon ledit deuxième mode de réalisation du procédé 1 expliqué ci-dessus et en relation avec les figures 1 à 8 et 10 comporte sensiblement un empilement consécutif de trois parties du type roue respectivement 39, 53 & 65 comportant une denture 59, 55 & 67. Cette pièce 51 est préférentiellement adaptée pour former une roue d'échappement destinée à coopérer avec une ancre d'échappement du type coaxial. Les dentures 55 et 67 en silicium sont alors avantageusement destinées à former les dentures d'impulsion destinées à coopérer avec les palettes de ladite ancre. La denture 59 métallique sert alors de pignon d'échappement destiné à réguler le mouvement auquel appartient la pièce de micromécanique 51.

Dans un troisième mode de réalisation illustré à la figure 9, on voit par exemple que l'étape de libération 33 du procédé 1 est réalisée après l'étape 25' de construction de la deuxième partie supplémentaire 39' métallique comme visualisé par les triples traits à la figure 10. L'étape de libération 33 consiste alors à éliminer non seulement les parties 71, 73 et 75 de résine photostructurée sur la partie supérieure du substrat 3 mais également celles présentes sur la couche inférieure dudit substrat. La pièce de micromécanique 51' ainsi fabriquée est libre par rapport au reste du substrat 3.

La pièce de micromécanique 51' comporte ainsi, comme visible à la figure 11, sur quatre couches empilées, une deuxième partie 39 métallique, une partie 53 en silicium et en oxyde de silicium dont au moins une portion d'une des cavités 45 comporte une partie 41 métallique, une deuxième partie 65 en silicium dont au moins une portion d'une des cavités 47 comporte une partie supplémentaire 41' métallique et une deuxième partie supplémentaire 39' métallique.

La pièce de micromécanique 51' obtenue selon ledit troisième mode de réalisation du procédé 1 expliqué ci-dessus et en relation avec les figures 1 à 7 et 9 à 11 comporte sensiblement un empilement consécutif de quatre couches du type roue respectivement 39, 53, 65 & 39' comportant une denture 59, 55, 67 & 59'.

Dans tous ces modes de réalisation, les pièces de micromécanique 51, 51', 51" sont avantageusement chassées non pas directement sur une partie 53 & 65 en silicium mais sur les parties métalliques 39, 39', 41 et 41'. Préférentiellement afin que, notamment, la partie métallique 41 isole suffisamment la partie 53 en silicium, l'épaisseur est supérieure à 6 microns. En effet, au-delà de cette épaisseur et idéalement à partir de 10 microns, un métal comme par exemple le nickel est capable d'absorber élastiquement ou plastiquement les efforts sans les restituer au silicium.

Il faut comprendre à la lecture de l'explication ci-dessus que les pièces de micromécanique 51, 51', 51" des figures ne sont que des exemples de réalisation qui montre que le procédé 1 permet de réaliser un empilement jusqu'à quatre couches (deux comportant du métal et deux comportant du silicium et du métal) sans complications excessives. La configuration du premier mode de réalisation pourrait ainsi constituer la plus simple des pièces de micromécanique et, celle du troisième mode de réalisation, une complication haute.

Dans une variante visualisé en traits interrompus courts à la figure 10, l'étape 29, réalisée entre les étapes 21 et 23, consistant à déposer la couche d'accrochage 61 peut être déplacée entre les étapes 15 et 17, c'est-à-dire entre l'attaque chimique de la couche intermédiaire 9 et le dépôt de la couche de résine photosensible 57. Préférentiellement, dans cette première variante, on choisira de doper les deux couches en silicium 5 et 7.

Bien entendu, la présente invention ne se limite pas à l'exemple illustré mais est susceptible de diverses variantes et modifications qui apparaîtront à l'homme de l'art. En particulier, d'autres couches 63 métalliques peuvent être envisagées comme par exemple de l'or, de l'aluminium, du chrome ou un de leur alliages. De même, d'autres couches d'accrochage 61 peuvent être envisagées si elles sont conductrices et qu'elles adhèrent parfaitement au métal choisi pour la couche 63 de croissance galvanique. Cependant, il est à noter que l'étape 29 de dépôt de la couche 61 n'est pas essentielle au bon déroulement de la croissance galvanique si les deux couches en silicium 5 et 7 sont dopées.

De même d'autres motifs que les dentures 55, 59, 59' & 67 peuvent être gravés comme des crochets ou des cliquets. Il est également à noter que la couche 63 peut être réalisée contre lesdits motifs gravés tels que les dentures 55, 59, 59' & 67 par exemple.

De même, la photolithographie peut, bien sûr, former une structure en négatif ou en positif suivant la résine photosensible employée ou l'application prévue. Le dépôt de la couche de résine 57 peut également être envisagé d'être réalisé par un processus connu sous le terme anglais de « spray coating ».

Enfin, la couche 63 métallique peut être réalisée aussi bien sur une portion de paroi intérieure d'une cavité 45 que sur la paroi périphérique d'au moins une des parties en silicium 53 et 65. La couche 63 peut également être structurée afin qu'elle soit reliée à ladite paroi en silicium par l'intermédiaire de ponts de matière.

## Revendications

1. Procédé de fabrication (1) d'une pièce de micromécanique (51, 51', 51 ") composite silicium - métal comprenant les étapes suivantes :
a) se munir (11) d'un substrat (3) comportant une couche supérieure (5) et une couche inférieure (7) en silicium entre lesquelles s'étend une couche intermédiaire (9) d'oxyde de silicium ;
b) graver (13) sélectivement au moins une cavité (37, 45, 45") dans la couche supérieure (5) pour définir le motif d'une partie (53, 53") en silicium de ladite pièce ;
c) continuer la gravure (15) de ladite au moins une cavité (37, 45, 45") dans la couche intermédiaire (9) ;
**caractérisé en ce qu'**il comporte en outre les étapes suivantes :
d) faire croître (17, 21, 23) une couche métallique (63) au moins à partir d'une portion de ladite au moins une cavité (37, 45, 45") afin de former une partie (41, 41', 41 ") métallique dans l'épaisseur de ladite pièce afin d'isoler mécaniquement la partie (53, 53") en silicium d'efforts destructifs ;
e) libérer (33) la pièce de micromécanique (51, 51', 51") composite silicium - métal du substrat (3).

2. Procédé (1) selon la revendication 1, **caractérisé en ce que** l'étape d) comporte les étapes suivantes :
- recouvrir (17) de résine photosensible (57) le dessus du substrat (3) ;
- réaliser (21) sélectivement une photolithographie de la résine photosensible (57) afin de la photostructurer (71, 73, 75) en fonction du motif prédéterminé de la partie (39, 41) métallique ;
- déposer (23) une couche métallique par électrodéposition à partir de la face supérieure conductrice de la couche inférieure (7) qui est à l'aplomb de ladite au moins une cavité (37, 45, 45") en y faisant croître, à partir du fond, la couche (63) entre respectivement la résine photostructurée (75) et la couche intermédiaire (9) ou supérieure (5) permettant de former la partie métallique (41, 41', 41 ") selon ledit motif ;
et **en ce que** l'étape e) est réalisée en éliminant (33) la résine photostructurée (71, 73, 75).

3. Procédé (1) selon la revendication 2, **caractérisé en ce que** ladite face supérieure conductrice de la couche inférieure (7) qui est à l'aplomb de ladite au moins une cavité (37, 45, 45") est rendue conductrice par dopage de la couche inférieure (7) et/ou par dépôt (29) d'une couche conductrice (61).

4. Procédé (1) selon la revendication 2 ou 3, **caractérisé en ce que** la résine photostructurée (71, 73, 75) lors de l'étape (21) de photolithographie fait saillie (73, 75) de la couche supérieure (5) du substrat (3) afin de pouvoir continuer la croissance de la couche (63) par électrodéposition (23) au moins entre lesdites saillies de la résine (73, 75) photostructurée dans le but de former une deuxième partie métallique (39) de la pièce de micromécanique (51, 51') au-dessus de la partie (53) en silicium.

5. Procédé (1) selon l'une des revendications précédentes, **caractérisé en ce qu'**il comporte, après l'étape d), une étape (25) d'usinage de la face supérieure du substrat (3) afin de niveler la couche métallique (63) à la même hauteur que l'extrémité supérieure de ladite résine photostructurée (73, 75).

6. Procédé (1) selon l'une des revendications précédentes, **caractérisé en ce que** la couche métallique (63, 39, 39', 41, 41', 41") comporte du nickel.

7. Procédé (1) selon l'une des revendications précédentes, **caractérisé en ce qu'**il comporte, avant l'étape de libération (33), des étapes d'usinage (27) et de gravage (31) d'au moins une cavité (47, 49) dans la couche inférieure (7) du substrat (3) afin de former une seconde partie (65) en silicium de la pièce de micromécanique (51, 51') selon une forme et une épaisseur déterminée.

8. Procédé (1) selon la revendication 7, **caractérisé en ce qu'**il comporte, entre les étapes (27, 31) d'usinage et de gravage de la couche inférieure (7) du substrat (3) et l'étape de libération (33), une étape (17', 21', 23') de croissance d'une deuxième couche métallique (41') par électrodéposition dans au moins une portion de ladite au moins une cavité (47) de la couche inférieure (7) afin de former au moins une partie métallique (41') supplémentaire dans l'épaisseur de la couche inférieure (7).

9. Procédé (1) selon la revendication 8, **caractérisé en ce que** l'étape de croissance comporte les étapes suivantes :
- recouvrir (17') de résine photosensible le dessous du substrat (3) ;
- réaliser (21') sélectivement une photolithographie de la résine photosensible afin de la photôstructurer en fonction du motif prédéterminé de la partie (41') métallique ;
- déposer (23') une couche métallique par électrodéposition à partir du fond de ladite au moins une cavité (47) en y faisant croître, à partir du fond, la couche permettant de former la partie métallique (41') selon ledit motif ;

10. Procédé (1) selon la revendication 9, **caractérisé en ce que** la résine photostructurée lors de l'étape (21') de photolithographie fait saillie de la couche inférieure (7) du substrat (3) afin de pouvoir continuer la croissance de la couche par électrodéposition (23') dans le but de former une deuxième partie métallique (39') supplémentaire de la pièce de micromécanique (51') en dessous de la deuxième partie (65) en silicium.

11. Procédé (1) selon l'une des revendications précédentes, **caractérisé en ce qu'**il comporte, avant l'étape (33) de libération, une étape (25') d'usinage de la face inférieure du substrat (3) afin de niveler la partie métallique (39') à la même hauteur que l'extrémité inférieure de ladite résine photostructurée.

12. Procédé (1) selon l'une des revendications 8 à 11, **caractérisé en ce que** la deuxième couche métallique électrodéposée (39', 41') comporte du nickel.

13. Procédé (1) selon l'une des revendications précédentes, **caractérisé en ce que** plusieurs pièces de micromécanique (51, 51', 51") sont fabriquées sur le même substrat (3).

## Patentansprüche

1. Verfahren (1) für die Herstellung eines mikromechanischen Silicium-Metall-Verbundteils (51, 51', 51"), das die folgenden Schritte umfasst:
a) Vorsehen (11) eines Substrats (3), das eine obere Schicht (5) und eine untere Schicht (7) aus Silicium enthält, zwischen denen sich eine Silicium-oxid-Zwischenschicht (9) erstreckt;
b) selektives Ätzen (13) wenigstens eines Hohlraums (37, 45, 45") in der oberen Schicht (5), um das Muster eines Abschnitts (53, 53") aus Silicium des Teils zu definieren;
c) Fortsetzen des Ätzens (15) des wenigstens einen Hohlraums (37, 45, 45") in der Zwischenschicht (9);
**dadurch gekennzeichnet, dass** es außerdem die folgenden Schritte umfasst:
d) Aufwachsenlassen (17, 21, 23) einer Metallschicht (63) wenigstens ausgehend von einem Abschnitt des wenigstens einen Hohlraums (37, 45, 45"), um einen metallischen Abschnitt (41, 41', 41") in Dickenrichtung des Teils zu bilden, um den Abschnitt (53, 53") aus Silicium gegenüber zerstörenden Kräften mechanisch zu isolieren;
e) Freigeben (33) des mikromechanischen Silicium-Metall-Verbundteils (51, 51', 51") von dem Substrat (3).

2. Verfahren (1) nach Anspruch 1, **dadurch gekennzeichnet, dass** der Schritt d) die folgenden Schritte umfasst:
- Abdecken (17) der Oberseite des Substrats (3) mit einem lichtempfindlichen Harz (57);
- wahlweises Herstellen (21) einer Photolithographie des lichtempfindlichen Harzes (57), um es gemäß dem vorgegebenen Muster des metallischen Abschnitts (39, 41) zu photostrukturieren (71, 73, 75);
- Ablagern (23) einer metallischen Schicht durch Metallisieren ausgehend von der leitenden oberen Fläche der unteren Schicht (7), die sich direkt über dem wenigstens einen Hohlraum (37, 45, 45") befindet, von wo sie ausgehend vom Boden aufwächst, wobei die Schicht (63) zwischen dem photostrukturierten Harz (75) und der Zwischenschicht (9) bzw. der oberen Schicht (5) ermöglicht, den metallischen Abschnitt (41, 41', 41") gemäß dem Muster zu formen;
und dass der Schritt e) durch Entfernen (33) des photostrukturierten Harzes (71, 73, 75) ausgeführt wird.

3. Verfahren (1) nach Anspruch 2, **dadurch gekennzeichnet, dass** die leitende obere Fläche der unteren Schicht (7), die sich direkt über dem wenigstens einen Hohlraum (37, 45, 45") befindet, durch Dotieren der unteren Schicht (7) und/oder durch Ablagern (29) einer leitenden Schicht (61) leitend gemacht wird.

4. Verfahren (1) nach Anspruch 2 oder 3, **dadurch gekennzeichnet, dass** das photostrukturierte Harz (71, 73, 75) im Schritt (21) der Photolithographie von der oberen Schicht (5) des Substrats (3) vorsteht (73, 75), um das Wachstum der Schicht (63) durch Metallisieren (23) wenigstens zwischen diesen Vorsprüngen des photostrukturierten Harzes (73, 75) fortsetzen zu können, mit dem Ziel, einen zweiten metallischen Abschnitt (39) des mikromechanischen Teils (51, 51') oberhalb des Abschnitts (53) aus Silicium zu bilden.

5. Verfahren (1) nach einem der vorhergehenden Ansprüche, **dadurch gekennzeichnet, dass** es nach dem Schritt d) einen Schritt (25) des Bearbeitens der oberen Fläche des Substrats (3) umfasst, um die metallische Schicht (63) auf dieselbe Höhe wie das obere Ende des photostrukturierten Harzes (73, 75) einzuebnen.

6. Verfahren (1) nach einem der vorhergehenden Ansprüche, **dadurch gekennzeichnet, dass** die metallische Schicht (63, 39, 39', 41, 41', 41 ") Nickel enthält.

7. Verfahren (1) nach einem der vorhergehenden Ansprüche, **dadurch gekennzeichnet, dass** es vor dem Schritt des Freigebens (33) Schritte des Bearbeitens (27) und des Ätzens (31) wenigstens eines Hohlraums (47, 49) in der unteren Schicht (7) des Substrats (3) umfasst, um einen zweiten Abschnitt (65) aus Silicium des mikromechanischen Teils (51, 51') mit einer bestimmten Form und einer bestimmten Dicke zu bilden.

8. Verfahren (1) nach Anspruch 7, **dadurch gekennzeichnet, dass** es zwischen den Schritten (27, 31) des Bearbeitens und Ätzens der unteren Schicht (7) des Substrats (3) und dem Freigabeschritt (33) einen Schritt (17', 21', 23') des Aufwachsenlassens einer zweiten metallischen Schicht (41') durch Metallisieren wenigstens in einem Abschnitt des wenigstens einen Hohlraums (47) der unteren Schicht (7) umfasst, um wenigstens einen zusätzlichen metallischen Abschnitt (41') in Dickenrichtung der unteren Schicht (7) zu bilden.

9. Verfahren (1) nach Anspruch 8, **dadurch gekennzeichnet, dass** der Wachstumsschritt die folgenden Schritte umfasst:
- Abdecken (17') der Unterseite des Substrats (3) mit einem lichtempfindlichen Harz;
- selektives Ausführen (21') einer Photolithographie des lichtempfindlichen Harzes, um es gemäß dem vorgegebenen Muster des metallischen Abschnitts (41') zu photostrukturieren;
- Ablagern (23') einer metallischen Schicht durch Metallisieren ausgehend vom Boden des wenigstens einen Hohlraums (47), von wo sie ausgehend vom Boden aufwächst, wobei die Schicht ermöglicht, den metallischen Abschnitt (41') gemäß dem Muster zu bilden.

10. Verfahren (1) nach Anspruch 9, **dadurch gekennzeichnet, dass** das photostrukturierte Harz im Photolithographieschritt (21') von der unteren Schicht (7) des Substrats (3) vorsteht, um das Wachstum der Schicht durch Metallisieren (23') fortsetzen zu können, mit dem Ziel, einen zweiten zusätzlichen metallischen Abschnitt (39') des mikromechanischen Teils (51') unter dem zweiten Abschnitt (65) aus Silicium zu bilden.

11. Verfahren (1) nach einem der vorhergehenden Ansprüche, **dadurch gekennzeichnet, dass** es vor dem Freigabeschritt (33) einen Schritt (25') des Bearbeitens der unteren Fläche des Substrats (3) umfasst, um den metallischen Abschnitt (39') auf dieselbe Höhe wie das untere Ende des photostrukturierten Harzes einzuebnen.

12. Verfahren (1) nach einem der Ansprüche 8 bis 11, **dadurch gekennzeichnet, dass** die zweite metallisierte metallische Schicht (39', 41') Nickel enthält.

13. Verfahren (1) nach einem der vorhergehenden Ansprüche, **dadurch gekennzeichnet, dass** auf demselben Substrat (3) mehrere mikromechanische Teile (51, 51', 51") hergestellt werden.

## Claims

1. Method of manufacturing (1) a silicon-metal composite micromechanical component (51, 51', 51") including the following steps:
a) taking (11) a substrate (3) including a top (5) and bottom (7) silicon layer between which an intermediate silicon oxide layer (9) extends,
b) selectively etching (13) at least one cavity (37, 45, 45") in the top layer (5) to define the pattern of a silicon part (53, 53") of said component;
c) continuing the etch (15) of said at least one cavity (37, 45, 45") in the intermediate layer (9);
**characterized in that** it further includes the following steps:
d) growing (17, 21, 23) a metal layer (63) at least from one portion of said at least one cavity (37, 45, 45") in order to form a metal part (41, 41', 41") in the thickness of said component in order to insulate the silicon part (53, 53") of said micromechanical component from destructive stress;
e) releasing (33) the silicon-metal composite micromechanical component (51, 51', 51") from the substrate (3).

2. Method (1) according to claim 1, **characterized in that** step d) includes the following steps:
- covering (17) the top of the substrate (3) with photosensitive resin (57);
- selectively performing (21) photolithography on the photosensitive resin (57) to photostructure (71, 73, 75) said resin in accordance with the predetermined pattern of the metal part (39, 41);
- depositing (23) a metal layer by electroplating, starting from the top conductive surface of the bottom layer (7), which is vertical to said at least one cavity (37, 45, 45") by growing, from the bottom, the layer (63) between respectively the photostructured resin (75) and the intermediate (9) or top (5) layer for forming the metal part (41, 41', 41") in accordance with said pattern; and **in that** step e) is performed by removing (33) the photostructured resin (71, 73, 75).

3. Method (1) according to claim 2, **characterized in that** said top conductive surface of the bottom layer (7), which is vertical to said at least once cavity (37, 45, 45") is made conductive by doping the bottom layer (7) and/or by the deposition (29) of a conductive layer (61).

4. Method (1) according to claim 2 or 3, **characterized in that**, during photolithography step (21), the photostructured resin (71, 73, 75) projects (73, 75) from the top layer (5) of the substrate (3) so that the layer (63) can continue to grow by electroplating (23) at least between said projecting portions of the photostructured resin (73, 75) in order to form a second metal part (39) of the micromechanical component (51, 51') above the silicon part (53).

5. Method (1) according to any of the preceding claims, **characterized in that**, after step d), it includes a step (25) of machining the top surface of the substrate (3) so as to level the metal layer (63) to the same height as the top end of said photostructured resin (73, 75).

6. Method (1) according to any of the preceding claims, **characterized in that** the metal layer (63, 39, 39', 41, 41', 41") includes nickel.

7. Method (1) according to any of the preceding claims, **characterized in that**, before the release step (33), it includes steps of machining (27) and etching (31) at least one cavity (47, 49) in the bottom layer (7) of the substrate (3) to form a second silicon part (65) in the micromechanical component (51, 51') in accordance with a determined shape and thickness.

8. Method (1) according to claim 7, **characterized in that**, between the steps of machining and etching (27, 31) the bottom layer (7) of the substrate (3), it includes a release step (33), a step (17', 21', 23') of growing a second metal layer (41') by electroplating in at least one portion of said at least one cavity (47) of the bottom layer (7) so as to form at least one additional metal part (41') in the thickness of the bottom layer (7).

9. Method (1) according to claim 8, **characterized in that** the growth step includes the following steps:
- covering (17') the bottom of the substrate (3) with photosensitive resin;
- selectively (21') performing photolithography on the photosensitive resin in order to photostructure said resin in accordance with the predetermined pattern of the metal part (41');
- depositing (23') a metal layer by electroplating starting from the bottom of said at least one cavity (47), by growing therein, from the bottom, the layer for forming the metal part (41') in accordance with said pattern.

10. Method (1) according to claim 9, **characterized in that**, during the photolithography step (21'), the photostructured resin projects from the bottom layer (7) of the substrate (3) so that the layer can continue to grow by electroplating (23') in order to form a second additional metal part (39') of the micromechanical component (51') below the second silicon part (65).

11. Method (1) according to any of the preceding claims, **characterized in that**, before the release step (33), it includes a step (25') of machining the bottom surface of the substrate (3) in order to level the metal part (39') to the same height as the bottom end of said photostructured resin.

12. Method (1) according to any of claims 8 to 11, **characterized in that** the second electroplated metal layer (39', 41') includes nickel.

13. Method (1) according to any of the preceding claims, **characterized in that** several micromechanical components (51, 51', 51") are manufactured in the same substrate (3).
